# EUROPEAN PATENT APPLICATION

(11) **EP 4 797 892 A1**
(43) Date of publication of application: **26.08.2026**
(21) Application number: 24878483.7
(22) Date of filing: 28.05.2024
(51) Int. Cl.: H05K 7/20

(54) **MAINTENANCE DEVICE, LIQUID COOLING SYSTEM ASSEMBLY, AND MAINTENANCE METHOD FOR LIQUID COOLING SYSTEM**

(30) Priority: 20.10.2023 CN 202311375974
(71) Applicant: ZTE CORPORATION, Shenzhen, Guangdong 518057 (CN)
(72) Inventor: ZHOU, Xiaodong, Shenzhen, Guangdong 518057 (CN); WANG, Yangkun, Shenzhen, Guangdong 518057 (CN); TAO, Cheng, Shenzhen, Guangdong 518057 (CN); LIU, Fan, Shenzhen, Guangdong 518057 (CN); LI, Shuai, Shenzhen, Guangdong 518057 (CN)
(74) Representative: Leihkauf, Steffen Falk
(86) International application number: PCT/CN2024/095817
(87) International publication number: WO 2025/081830

(57) **Abstract**

The present disclosure provides a maintenance device, a liquid cooling system assembly, and a maintenance method for a liquid cooling system. The maintenance device includes a maintenance unit and a hose reel unit. The maintenance unit is configured to replace at least part of the liquid cooling system after one end of a component to be replaced of the liquid cooling system is removed and before a replacement component is installed, so that a liquid cooling medium can circulate and flow between a liquid cooling source and a heat exchange component of the liquid cooling system; the maintenance unit is at least partially stored in the hose reel unit; in a case where the maintenance unit maintains the component to be replaced, at least part of the maintenance unit located at the hose reel unit can be released; in a case where the replacement component is installed, at least part of the maintenance unit located outside the hose reel unit can be stored in the hose reel unit.

## Description

### Cross-Reference to Related Application

The present disclosure is based upon and claims priority to Chinese Patent Application No. CN202311375974.3, filed on October 20, 2023 and entitled "Maintenance Device, Liquid Cooling System Assembly, and Maintenance Method for Liquid Cooling System", the disclosure of which is hereby incorporated by reference in its entirety.

### Technical Field

The present disclosure relates to the technical field of liquid cooling systems, and in particular, to a maintenance device, a liquid cooling system assembly, and a maintenance method for a liquid cooling system.

### Background

With the rapid development of communication technology, the power consumption of device and chips is increasing, posing huge challenges to heat dissipation. Liquid cooling technology has gradually attracted attention due to its advantages such as strong heat dissipation capability, energy saving, and noise reduction. In order to effectively dissipate heat from components to be cooled in computer room equipment, a liquid cooling system usually includes a liquid cooling source, a liquid supply pipeline, and a liquid return pipeline. The liquid cooling source is used for supplying a heat exchange medium to the liquid supply pipeline. The heat exchange medium flowing out from the liquid supply pipeline can cool a plurality of components to be cooled. Afterwards, the heat exchange medium rises in temperature and flows back to the liquid cooling source through the liquid return pipeline. The heat exchange medium is cooled in the liquid cooling source and then flows into the liquid supply pipeline again, thereby forming a liquid cooling cycle. However, when a certain component in the liquid cooling system or the liquid cooling system fails, it is difficult to achieve rapid replacement. Once a failure occurs, the cost is huge, causing abnormal liquid cooling of the corresponding component to be cooled and bringing significant losses, especially affecting routers and switches that have high requirements for device reliability.

### Summary

The present disclosure provides a maintenance device, a liquid cooling system assembly, and a maintenance method for a liquid cooling system, aiming to rapidly achieve replacement of a component to be replaced of a liquid cooling pipeline assembly of the liquid cooling system.

According to a first aspect of the present disclosure, a maintenance device is provided for maintaining a liquid cooling system. The maintenance device includes: a maintenance unit, configured to replace at least part of the liquid cooling system after one end of a component to be replaced of the liquid cooling system is removed and before a replacement component is installed, so that a liquid cooling medium can circulate and flow between a liquid cooling source and a heat exchange component of the liquid cooling system; and a hose reel unit, where the maintenance unit is at least partially stored in the hose reel unit; in a case where the maintenance unit maintains the component to be replaced, at least part of the maintenance unit located at the hose reel unit can be released; and in a case where the replacement component is installed, at least part of the maintenance unit located outside the hose reel unit can be stored in the hose reel unit.

A second aspect of the present disclosure provides a liquid cooling system assembly, including: a liquid cooling system; and the maintenance device as described above, configured to maintain the liquid cooling system or a liquid cooling pipeline assembly of the liquid cooling system.

A third aspect of the present disclosure provides a maintenance method for a liquid cooling system. The liquid cooling system includes a liquid cooling source, a heat exchange component, and a liquid cooling pipeline assembly. The maintenance method includes: replacing a component to be replaced of the liquid cooling system with a replacement component, and installing at least part of a maintenance device after one end of the component to be replaced is removed and before the replacement component is installed, so that a liquid cooling medium can circulate and flow between the liquid cooling source and the heat exchange component, where the maintenance device includes the maintenance device according to any one of the above items.

### Brief Description of the Drawings

In order to more clearly illustrate the technical solutions of the embodiments of the present disclosure, the drawings required for the description of the embodiments will be briefly introduced below. It is apparent that the drawings described below are some embodiments of the present disclosure. For those of ordinary skill in the art, other drawings can also be obtained based on these drawings without making creative labor.
Fig. 1 is a schematic structural diagram of a liquid cooling system provided by an embodiment of the present disclosure.
Fig. 2 is a schematic application diagram of a maintenance device provided by an embodiment of the present disclosure.
Fig. 3 is a schematic application diagram of a maintenance device provided by another embodiment of the present disclosure.
Fig. 4 is a schematic structural diagram of a maintenance device provided by an embodiment of the present disclosure.
Fig. 5 is a schematic structural diagram of a hose reel unit provided by an embodiment of the present disclosure.
Fig. 6 is a schematic structural diagram of a maintenance device provided by another embodiment of the present disclosure.
Fig. 7 is a schematic structural diagram of a winding member provided by an embodiment of the present disclosure.
Fig. 8 is a schematic structural diagram of a maintenance device provided by yet another embodiment of the present disclosure.
Fig. 9 is a schematic structural diagram of a maintenance liquid distributor provided by an embodiment of the present disclosure.

### Description of reference signs:

100, liquid cooling system; 10, liquid cooling source; 20, heat exchange component; 21, first heat exchange component; 22, second heat exchange component; 30, liquid cooling pipeline assembly; 301, liquid inlet pipeline group; 302, liquid outlet pipeline group; 31, main delivery pipeline; 32, first liquid distributor; 33, first tertiary branch; 34, secondary branch; 35, second liquid distributor; 36, second tertiary branch; 37, quick-release connector;
200, maintenance device;
201, maintenance unit; 2011, main maintenance pipeline; 2012, maintenance liquid distributor; 20121, first connection interface; 20122, second connection interface; 20123, third connection interface; 20124, fourth connection interface; 2013, first maintenance pipeline; 2014, second maintenance pipeline;
202, hose reel unit; 2021, storage mechanism; 20211, winding member; 20212, housing cover; 2022, retraction mechanism;
203, pre-treatment unit; 2031, liquid replenishment mechanism; 20311, liquid storage tank; 20312, weighing scale; 2032, negative pressure mechanism;
204, control unit; 205, recovery unit; 2051, recovery tank; 2052, recovery machine; 206, power supply unit; 207, frame;
300, computer room equipment.

### Detailed Description of the Embodiments

The technical solutions in the embodiments of the present disclosure will be clearly and completely described below in conjunction with the drawings in the embodiments of the present disclosure. It is apparent that the described embodiments are part, rather than all, of the embodiments of the present disclosure. Based on the embodiments in the present disclosure, all other embodiments obtained by those of ordinary skill in the art without making creative efforts belong to the scope of protection of the present disclosure.

In the description of the present disclosure, it should be understood that the orientations or positional relationships indicated by terms such as "center", "longitudinal", "transverse", "length", "width", "thickness", "upper", "lower", "front", "rear", "left", "right", "vertical", "horizontal", "top", "bottom", "inner", "outer", "clockwise", "counterclockwise", etc., are based on the orientations or positional relationships shown in the drawings, merely for the convenience of describing the present disclosure and simplifying the description, and do not indicate or imply that the referred device or element must have a specific orientation, be constructed or operated in a specific orientation, and therefore cannot be understood as a limitation on the present disclosure. In addition, the terms "first" and "second" are used for descriptive purposes only and should not be understood as indicating or implying relative importance or implicitly indicating the number of the indicated technical features. Thus, a feature defined with "first" or "second" may explicitly or implicitly include one or more of the features. In the description of the present disclosure, the meaning of "a plurality of" is two or more, unless otherwise explicitly and specifically limited

It should further be understood that the terms used in the specification of the present disclosure are merely for the purpose of describing specific embodiments and are not intended to limit the present disclosure. As used in the specification of the present disclosure and the appended claims, the singular forms "a", "an", and "the" are intended to include the plural forms as well, unless otherwise clearly indicated in the context.

It should be further understood that the term "and/or" used in the specification of the present disclosure and the appended claims refers to any combination of one or more of the associated listed items and all possible combinations, and includes these combinations.

It should further be understood that the methods in the embodiments of the present disclosure are merely exemplary illustrations, and do not necessarily include all contents and operations/steps, nor must they be executed in the described order. For example, some operations/steps can also be decomposed, combined, or partially merged, so the actual execution order may change according to actual conditions.

With the continuous innovation and development of Information and Communications Technology (ICT), the power density of communication products is gradually increasing. Conventional air-cooled equipment is gradually facing a transition to liquid cooling. However, how to achieve online maintenance of the liquid cooling system without service interruption has become a key bottleneck restricting the implementation of liquid cooling technology.

Based on this, embodiments of the present disclosure provide a maintenance device, a liquid cooling system assembly, and a maintenance method for a liquid cooling system.

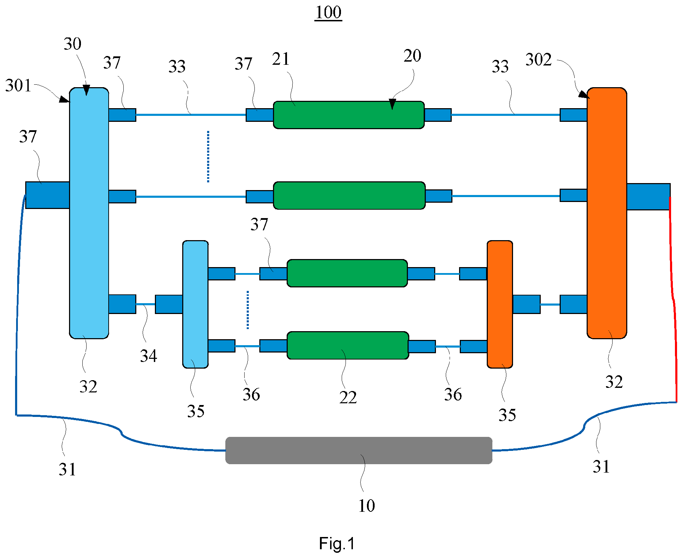

Referring to Fig. 1, embodiments of the present disclosure provide a liquid cooling system 100. The liquid cooling system 100 is configured to dissipate heat from a component to be cooled, so as to dissipate the heat of the component to be cooled in time, thereby ensuring normal operation of the component to be cooled.

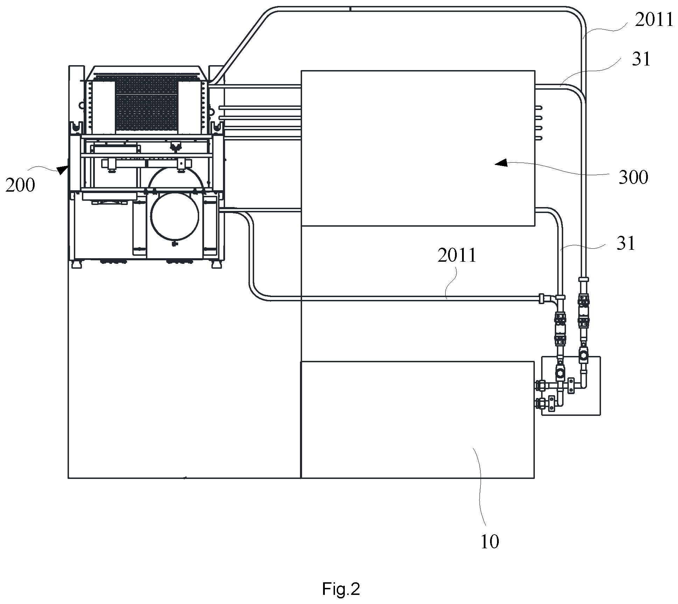

Referring to Fig. 1, in some embodiments, the liquid cooling system 100 includes a liquid cooling source 10 and a heat exchange component 20. The liquid cooling source 10 is configured to supply a liquid cooling medium, and the heat exchange component 20 is configured to perform heat exchange with the component to be cooled, so as to dissipate the heat at the component to be cooled in time. Exemplarily, the component to be cooled may include at least one of the following: a server, a router, a switch, a heat-generating component in computer room equipment 300 (please refer to Fig. 2), etc.

It can be understood that the liquid cooling medium flowing out from the liquid cooling source 10 can flow to the heat exchange component 20. The liquid cooling medium flowing to the heat exchange component 20 can undergo heat exchange with the heat exchange component 20. The liquid cooling medium flowing through the heat exchange component 20 increases in temperature, so as to dissipate the heat at the heat exchange component 20, and further dissipate the heat of the component to be cooled in time; the liquid cooling medium flowing out from the heat exchange component 20 can flow back to the liquid cooling source 10. The liquid cooling medium flowing back to the liquid cooling source 10 is cooled in the liquid cooling source 10 and then flows to the heat exchange component 20 again, thereby forming a liquid cooling cycle.

Exemplarily, the liquid cooling source 10 includes a Cooling Dispensing Unit (CDU). Exemplarily, the heat exchange component 20 includes a cold plate or a service unit.

Exemplarily, the liquid cooling medium is in a gaseous state at normal temperature and pressure, and can be converted into a liquid state under preset pressure conditions or preset temperature conditions.

Exemplarily, the liquid cooling medium includes at least one of the following: hydrofluoroether, perfluorocarbon, etc.

Referring to Fig. 1, in some embodiments, the liquid cooling system 100 further includes a liquid cooling pipeline assembly 30. The liquid cooling pipeline assembly 30 is configured to connect to the liquid cooling source 10 and the heat exchange component 20, so that the liquid cooling medium can circulate and flow between the liquid cooling source 10 and the heat exchange component 20.

Referring to Fig. 1, in some implementations, the liquid cooling pipeline assembly 30 includes a liquid inlet pipeline group 301 and a liquid outlet pipeline group 302. The liquid cooling source 10, the liquid inlet pipeline group 301, the heat exchange component 20, and the liquid outlet pipeline group 302 are connected to form a circulation loop. The liquid cooling medium flowing out from the liquid cooling source 10 flows through the liquid inlet pipeline group 301 and enters the heat exchange component 20. When the liquid cooling medium flows through the heat exchange component 20, it can absorb heat of the heat exchange component 20, and part of the liquid cooling medium vaporizes. The liquid cooling medium flowing out from the heat exchange component 20 can flow back to the liquid cooling source 10 through the liquid outlet pipeline group 302.

Exemplarily, the structure of the liquid inlet pipeline group 301 and the structure of the liquid outlet pipeline group 302 can be the same or different, which is not limited herein.

Referring to Fig. 1, exemplarily, the heat exchange component 20 includes a first heat exchange component 21 and a second heat exchange component 22. The liquid inlet pipeline group 301 includes a main delivery pipeline 31, a first liquid distributor 32, a first tertiary branch 33, a secondary branch 34, a second liquid distributor 35, and a second tertiary branch 36. The liquid cooling source 10 is connected to the first liquid distributor 32 through the main delivery pipeline 31. The first tertiary branch 33 and the secondary branch 34 are respectively connected to the first liquid distributor 32. The first liquid distributor 32 is connected to the first heat exchange component 21 through the first tertiary branch 33. The first liquid distributor 32 is connected to the second liquid distributor 35 through the secondary branch 34. The second liquid distributor 35 is connected to the second heat exchange component 22 through the second tertiary branch 36. The structures of the liquid inlet pipeline group 301 and the liquid outlet pipeline group 302 are the same or substantially the same.

In some implementations, the numbers of the first heat exchange component 21 and the second heat exchange component 22 can both be designed according to actual needs, for example, one, two, three, four, five, six, seven, eight, nine, or more. The numbers of the first tertiary branch 33, the secondary branch 34, the second liquid distributor 35, and the second tertiary branch 36 can all be set according to actual needs, for example, one, two, three, or more. Exemplarily, the number of the first tertiary branch 33 of the liquid inlet pipeline group 301 is the same as the number of the first heat exchange component 21, and the number of the second tertiary branch 36 of the liquid inlet pipeline group 301 is the same as the number of the second heat exchange component 22.

In other embodiments, the secondary branch 34, the second liquid distributor 35, the second tertiary branch 36, and the second heat exchange component 22 can also be omitted, which is not limited herein.

Referring to Fig. 1, in some embodiments, the liquid cooling system 100 further includes a quick-release connector 37. The quick-release connector 37 is detachably connected between adjacent pipeline components in the liquid cooling pipeline assembly 30, or the quick-release connector 37 is detachably connected between the heat exchange component 20 and the liquid cooling pipeline assembly 30. Exemplarily, the number of the quick-release connector 37 is at least two. A quick-release connector 37 is provided between two adjacent pipeline components in the liquid cooling pipeline assembly 30 to achieve detachable connection of the two adjacent pipeline components, facilitating rapid removal of the component to be replaced and installation of the replacement component when replacing the component to be replaced, thereby improving maintenance efficiency. Exemplarily, a quick-release connector 37 is provided at the connection between the heat exchange component 20 and the liquid cooling pipeline assembly 30 to achieve detachable connection between the heat exchange component 20 and the liquid cooling pipeline assembly 30, facilitating rapid installation and detachment of the heat exchange component 20 and the corresponding pipeline component when replacing the component to be replaced, providing a guarantee for achieving rapid replacement of the component to be replaced. For example, a quick-release connector 37 is provided at the connection between the first heat exchange component 21 and the first tertiary branch 33 to achieve detachable connection between the first heat exchange component 21 and the first tertiary branch 33. For another example, a quick-release connector 37 is provided at the connection between the second heat exchange component 22 and the second tertiary branch 36 to achieve detachable connection between the second heat exchange component 22 and the second tertiary branch 36.

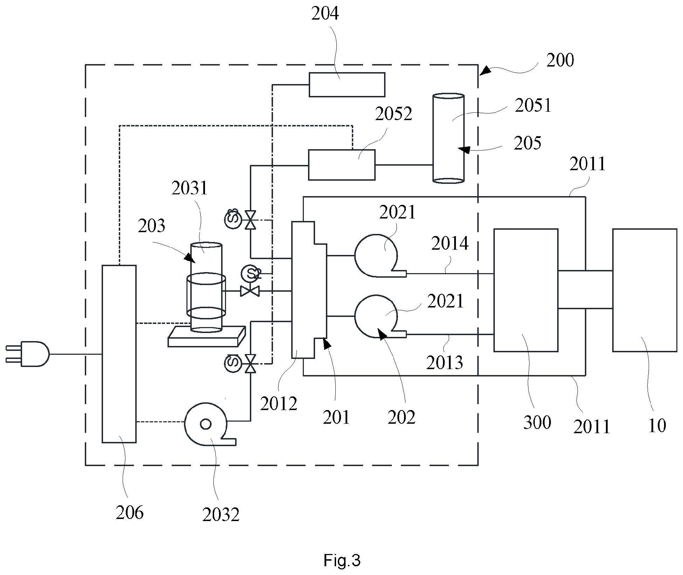

Referring to Fig. 2 and Fig. 3, in some implementations, the heat exchange component 20 and at least part of the liquid cooling pipeline assembly 30 are configured to be disposed in the computer room equipment 300, so as to dissipate heat from the component to be cooled in the computer room equipment 300. Exemplarily, the heat exchange component 20 and at least part of the liquid cooling pipeline assembly 30 can belong to a part of the computer room equipment 300. Exemplarily, the heat exchange component 20 or at least part of the liquid cooling pipeline assembly 30 can also not belong to a part of the computer room equipment 300, which is not limited herein.

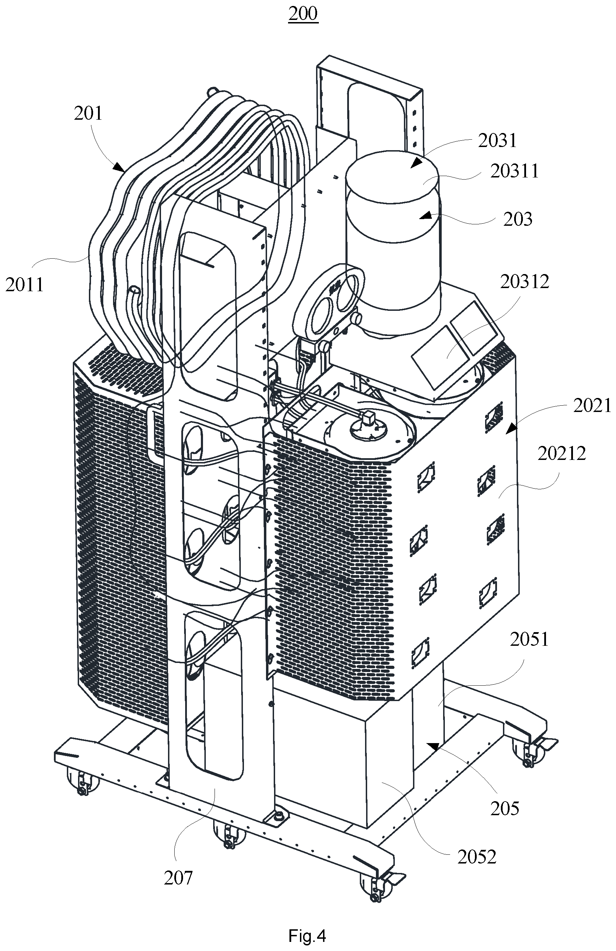

Referring to Fig. 1 and Fig. 4, embodiments of the present disclosure provide a maintenance device 200, configured to maintain the liquid cooling system 100 or the liquid cooling pipeline assembly 30 of the liquid cooling system 100.

Referring to Fig. 3 and Fig. 4, in some embodiments, the maintenance device 200 includes a maintenance unit 201 and a hose reel unit 202. The maintenance unit 201 is configured to replace at least part of the liquid cooling system 100 after one end of a component to be replaced of the liquid cooling system 100 is removed and before a replacement component is installed, so that a liquid cooling medium can circulate and flow between the liquid cooling source 10 and the heat exchange component 20 of the liquid cooling system 100; the maintenance unit 201 is at least partially stored in the hose reel unit 202; in a case where the maintenance unit 201 maintains the component to be replaced, at least part of the maintenance unit 201 located at the hose reel unit 202 can be released; in a case where the replacement component is installed, at least part of the maintenance unit 201 located outside the hose reel unit 202 can be stored in the hose reel unit 202.

In the maintenance device 200 of the above embodiment, when a component of the liquid cooling system 100 fails or is damaged, the component to be replaced (i.e., the failed or damaged component of the liquid cooling system 100) can be rapidly replaced through the maintenance device 200, achieving online maintenance of the component to be replaced without stopping the component to be cooled, reducing the risk of the component to be cooled facing failure and shutdown, and reducing communication accidents caused by the shutdown of the component to be cooled; the user experience is also improved, enhancing product reliability and competitiveness.

Exemplarily, the component to be replaced includes at least one of the following: at least one component of the liquid cooling pipeline assembly 30 of the liquid cooling system 100, the heat exchange component 20, etc. For example, the component to be replaced includes at least one of the following: the main delivery pipeline 31, the first liquid distributor 32, the secondary branch 34, and the second liquid distributor 35. For another example, the component to be replaced includes at least one of the following: the first tertiary branch 33 and the second tertiary branch 36. For yet another example, the component to be replaced includes the heat exchange component 20.

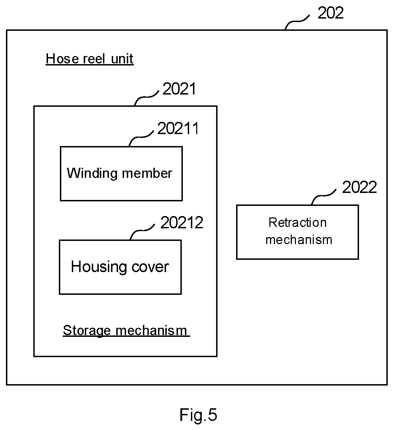

Referring to Fig. 5, in some embodiments, the hose reel unit 202 includes a storage mechanism 2021 and a retraction mechanism 2022. The maintenance unit 201 is at least partially stored in the storage mechanism 2021; the retraction mechanism 2022 is connected to the storage mechanism 2021; in a case where the maintenance unit 201 maintains the component to be replaced, at least part of the maintenance unit 201 located at the storage mechanism 2021 can be released; in a case where the replacement component is installed, the maintenance unit 201 located outside the storage mechanism 2021 can be stored in the storage mechanism 2021 under an action of the retraction mechanism 2022. It can be understood that when the component to be replaced of the liquid cooling system 100 needs to be replaced, a user or other auxiliary equipment can pull at least part of the maintenance unit 201 outward, so that at least part of the maintenance unit 201 located at the storage mechanism 2021 can be released, to better connect to corresponding components of the liquid cooling system 100 (such as the heat exchange component 20 or a first pipeline, where the first pipeline includes the first tertiary branch 33 or the second tertiary branch 36). In a case where the replacement component is installed, the maintenance unit 201 released from the storage mechanism 2021 can be automatically stored in the storage mechanism 2021 under the action of the retraction mechanism 2022, reducing the occupied space of the maintenance unit 201 and the maintenance device 200, conductive to achieving miniaturization of the maintenance device 200 and facilitating storage and transportation of the maintenance device 200; the need for the user to manually store at least part of the maintenance unit 201 is eliminated, freeing the user's hands. It can be understood that the replacement component is a replacement structure for the component to be replaced. For example, in a case where the component to be replaced includes the first liquid distributor 32, the replacement component is a new first liquid distributor 32.

Exemplarily, the retraction mechanism 2022 includes an elastic member, such as a spring or a torsion spring, etc. In other embodiments, the retraction mechanism 2022 can also be omitted.

In some embodiments, in a case where the maintenance unit 201 maintains the component to be replaced, the storage mechanism 2021 can move along a first movement direction to release at least part of the maintenance unit 201 outwardly; in a case where the replacement component is installed, the hose reel unit 202 can move along a second movement direction under an action of the retraction mechanism 2022 to store at least part of the maintenance unit 201 located outside the hose reel unit 202 into the hose reel unit 202, where the first movement direction is different from the second movement direction. Exemplarily, the first movement direction is opposite to the second movement direction. Exemplarily, at least part of the maintenance unit 201 includes at least one of the following: the main maintenance pipeline 2011, the first maintenance pipeline 2013, and the second maintenance pipeline 2014.

In some embodiments, at least part of the maintenance unit 201 can be wound around the storage mechanism 2021; the storage mechanism 2021 can rotate to release or store at least part of the maintenance unit 201. In this way, the storage mechanism 2021 can orderly store or release at least part of the maintenance unit 201, conducive to further reducing the occupied space of the maintenance unit 201 and the maintenance device 200.

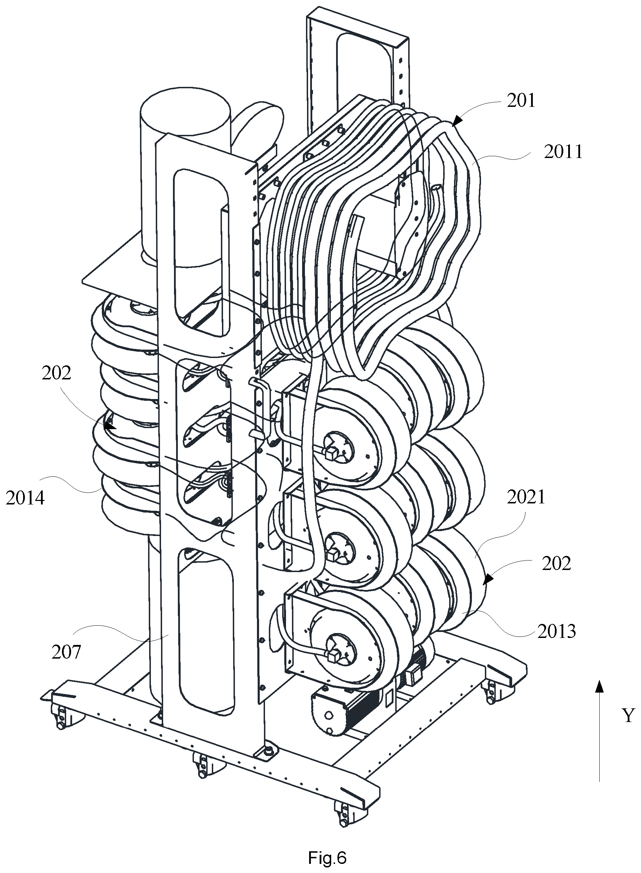

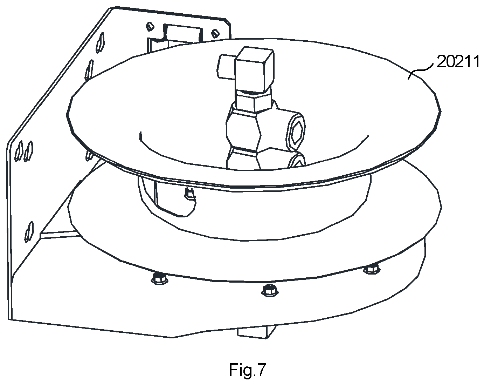

Referring to Fig. 6 and Fig. 7, in some embodiments, the storage mechanism 2021 includes a winding member 20211 and a housing cover 20212. At least part of the maintenance unit 201 can be wound around the winding member 20211. The winding member 20211 can rotate to release or store at least part of the maintenance unit 201. The housing cover 20212 is configured to cover the winding member 20211 and the maintenance unit 201 stored at the winding member 20211, thereby protecting the maintenance unit 201 wound around the winding member 20211 to a certain extent, playing a role in dust prevention or liquid prevention, and making the maintenance device 200 more aesthetically pleasing.

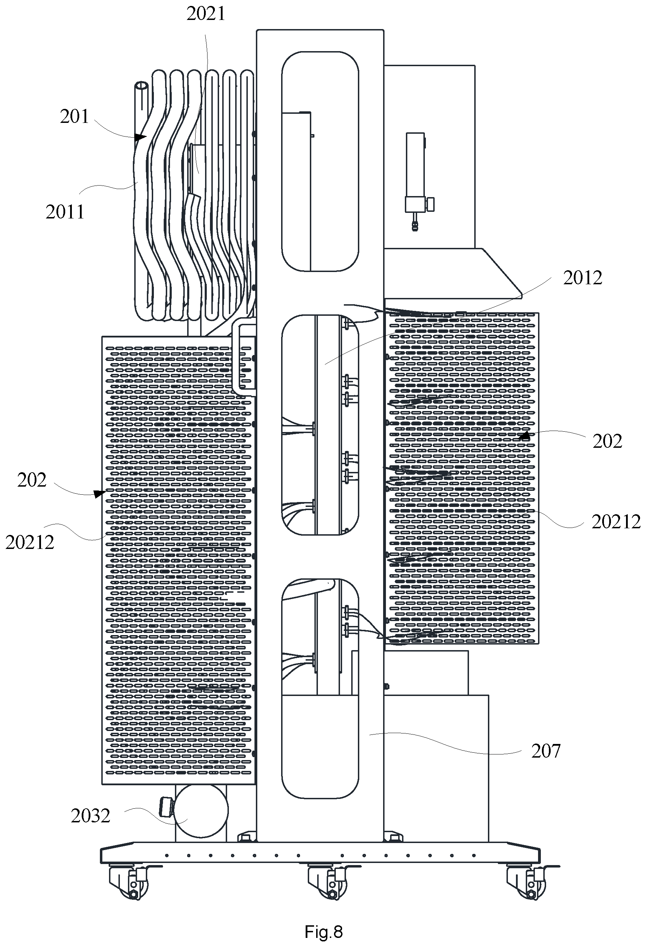

Referring to Fig. 6 and Fig. 8, in some embodiments, the maintenance unit 201 includes a main maintenance pipeline 2011 and a maintenance liquid distributor 2012. The main maintenance pipeline 2011 is configured to communicate with the liquid cooling source 10; the maintenance liquid distributor 2012 can communicate with the main maintenance pipeline 2011, and the main maintenance pipeline 2011 is correspondingly provided with the hose reel unit 202, so as to reduce the storage volume of the maintenance unit 201 and the maintenance device 200.

Referring to Fig. 6 and Fig. 8, in some embodiments, the maintenance unit 201 includes a main maintenance pipeline 2011, a maintenance liquid distributor 2012, and a first maintenance pipeline 2013. The main maintenance pipeline 2011 is configured to communicate with the liquid cooling source 10; the maintenance liquid distributor 2012 can communicate with the main maintenance pipeline 2011; the first maintenance pipeline 2013 and the main maintenance pipeline 2011 are respectively connected to the maintenance liquid distributor 2012; at least one of the first maintenance pipeline 2013 and the main maintenance pipeline 2011 is correspondingly provided with the hose reel unit 202, so as to reduce the storage volume of the maintenance unit 201 and the maintenance device 200. For example, one of the first maintenance pipeline 2013 and the main maintenance pipeline 2011 is correspondingly provided with the hose reel unit 202. For another example, the first maintenance pipeline 2013 and the main maintenance pipeline 2011 are respectively provided with the hose reel unit 202 correspondingly, so as to minimize the storage volume of the maintenance unit 201 and the maintenance device 200 as much as possible.

Referring to Fig. 6 and Fig. 8, in some embodiments, the main maintenance pipeline 2011 and the first maintenance pipeline 2013 are disposed on a same side of the maintenance liquid distributor 2012, so as to reasonably arrange the positions of the main maintenance pipeline 2011 and the first maintenance pipeline 2013, reasonably utilize the space around the maintenance liquid distributor 2012, make the structure of the maintenance device 200 compact, and occupy small space.

In some embodiments, the first maintenance pipeline 2013 and the main maintenance pipeline 2011 are respectively provided with the hose reel unit 202 correspondingly. The hose reel unit 202 corresponding to the first maintenance pipeline 2013 and the hose reel unit 202 corresponding to the main maintenance pipeline 2011 are arranged along a first direction, making the maintenance device 200 reasonable in structural layout, compact in structure, and occupy small space.

Exemplarily, the first direction is shown as the Y direction in Fig. 6.

Exemplarily, the first direction is an up-down direction of the maintenance device 200.

Referring to Fig. 6, in some embodiments, the maintenance unit 201 further includes a second maintenance pipeline 2014. The second maintenance pipeline 2014 is connected to the maintenance liquid distributor 2012. At least one of the first maintenance pipeline 2013, the second maintenance pipeline 2014, and the main maintenance pipeline 2011 is correspondingly provided with the hose reel unit 202, so as to reduce the storage volume of the maintenance unit 201 and the maintenance device 200. For example, one of the first maintenance pipeline 2013, the second maintenance pipeline 2014, and the main maintenance pipeline 2011 is correspondingly provided with the hose reel unit 202. For another example, any two of the first maintenance pipeline 2013, the second maintenance pipeline 2014, and the main maintenance pipeline 2011 are respectively provided with the hose reel unit 202 correspondingly. For yet another example, the first maintenance pipeline 2013, the second maintenance pipeline 2014, and the main maintenance pipeline 2011 are respectively provided with the hose reel unit 202 correspondingly, so as to minimize the storage volume of the maintenance unit 201 and the maintenance device 200 as much as possible. It can be understood that the structures of the hose reel unit 202 correspondingly provided for the first maintenance pipeline 2013, the second maintenance pipeline 2014, and the main maintenance pipeline 2011 can be the same or different, which is not limited herein.

Referring to Fig. 6 and Fig. 8, in some embodiments, the first maintenance pipeline 2013 and the second maintenance pipeline 2014 are respectively disposed on opposite sides of the maintenance liquid distributor 2012, so as to fully utilize the space around the maintenance liquid distributor 2012, make the structure of the maintenance device 200 more compact, and make the occupied space of the maintenance device 200 small.

Exemplarily, in a case of maintaining the liquid cooling system 100, the first maintenance pipeline 2013 is configured to connect to the first tertiary branch 33 or the first heat exchange component 21, and the second maintenance pipeline 2014 is configured to connect to the second tertiary branch 36 or the second heat exchange component 22. Exemplarily, when maintaining the liquid cooling system 100, the first maintenance pipeline 2013 is configured to connect to the second tertiary branch 36 or the second heat exchange component 22, and the second maintenance pipeline 2014 is configured to connect to the first tertiary branch 33 or the first heat exchange component 21.

Exemplarily, in a case of maintaining a component to be replaced (such as the first liquid distributor 32 of the liquid cooling system 100 or other pipeline components, etc.), one of the first maintenance pipeline 2013 and the second maintenance pipeline 2014 can be configured to connect to the first heat exchange component 21 or the first tertiary branch 33 of the liquid cooling system 100, and the other of the first maintenance pipeline 2013 and the second maintenance pipeline 2014 can be configured to connect to the second heat exchange component 22 or the second tertiary branch 36 of the liquid cooling system 100 according to actual needs.

Exemplarily, the main maintenance pipeline 2011 includes a main maintenance liquid inlet pipeline (not labeled) and a main maintenance liquid outlet pipeline (not labeled). When the main maintenance pipeline 2011 needs to be used for maintaining the liquid cooling system 100, the main maintenance liquid inlet pipeline and the main maintenance liquid outlet pipeline can be released from the storage mechanism 2021 synchronously or non-synchronously; when the maintenance of the liquid cooling system 100 is completed, at least part of the main maintenance liquid inlet pipeline and at least part of the main maintenance liquid outlet pipeline can be stored in the storage mechanism 2021 synchronously or non-synchronously. The main maintenance liquid inlet pipeline and the main maintenance liquid outlet pipeline can share one storage mechanism 2021, or, the main maintenance liquid inlet pipeline and the main maintenance liquid outlet pipeline can be separately provided with a storage mechanism 2021 respectively.

It can be understood that one of the two main maintenance pipelines 2011 in Fig. 2 is the main maintenance liquid inlet pipeline, and the other is the main maintenance liquid outlet pipeline. One of the two main delivery pipelines 31 in Fig. 2 is the main delivery pipeline 31 of the liquid inlet pipeline group 301, and the other is the main delivery pipeline 31 of the liquid outlet pipeline group 302.

Exemplarily, the first maintenance pipeline 2013 includes a first maintenance liquid inlet pipeline (not labeled) and a first maintenance liquid outlet pipeline (not labeled). When the first maintenance pipeline 2013 needs to be used for maintaining the liquid cooling system 100, the first maintenance liquid inlet pipeline and the first maintenance liquid outlet pipeline can be released from the storage mechanism 2021 synchronously or non-synchronously; when the maintenance of the liquid cooling system 100 is completed, at least part of the first maintenance liquid inlet pipeline and at least part of the first maintenance liquid outlet pipeline can be stored in the storage mechanism 2021 synchronously or non-synchronously. The first maintenance liquid inlet pipeline and the first maintenance liquid outlet pipeline can share one storage mechanism 2021, or, the first maintenance liquid inlet pipeline and the first maintenance liquid outlet pipeline can be separately provided with a storage mechanism 2021 respectively. Exemplarily, the first maintenance liquid inlet pipeline and the first maintenance liquid outlet pipeline are respectively connected to the main maintenance liquid inlet pipeline and the main maintenance liquid outlet pipeline of the main maintenance pipeline 2011.

Exemplarily, the second maintenance pipeline 2014 includes a second maintenance liquid inlet pipeline (not labeled) and a second maintenance liquid outlet pipeline (not labeled). When the second maintenance pipeline 2014 needs to be used for maintaining the liquid cooling system 100, the second maintenance liquid inlet pipeline and the second maintenance liquid outlet pipeline can be released from the storage mechanism 2021 synchronously or non-synchronously; when the maintenance of the liquid cooling system 100 is completed, at least part of the second maintenance liquid inlet pipeline and at least part of the second maintenance liquid outlet pipeline can be stored in the storage mechanism 2021 synchronously or non-synchronously. The second maintenance liquid inlet pipeline and the second maintenance liquid outlet pipeline can share one storage mechanism 2021, or, the second maintenance liquid inlet pipeline and the second maintenance liquid outlet pipeline can be separately provided with a storage mechanism 2021 respectively. Exemplarily, the second maintenance liquid inlet pipeline and the second maintenance liquid outlet pipeline are respectively connected to the main maintenance liquid inlet pipeline and the main maintenance liquid outlet pipeline of the main maintenance pipeline 2011.

Referring to Fig. 4, in some embodiments, the maintenance device 200 further includes a pre-treatment unit 203. The pre-treatment unit 203 is configured to perform at least one of the following pre-treatment functions: providing a negative pressure environment for the maintenance unit 201 and the replacement component; performing liquid replenishment for the maintenance unit 201 and the replacement component, so as to ensure that the maintenance unit 201 can normally maintain the liquid cooling system 100.

In some implementations, at least part of the pre-treatment unit 203 and the second maintenance pipeline 2014 are disposed on a same side of the maintenance liquid distributor 2012, or, at least part of the pre-treatment unit 203 and the main maintenance pipeline 2011 are disposed on a same side of the maintenance liquid distributor 2012, so as to fully utilize the space around the maintenance liquid distributor 2012, reasonably layout the maintenance device 200, make the structure of the maintenance device 200 compact, and occupy small space.

Referring to Fig. 3 and Fig. 4, in some embodiments, the pre-treatment unit 203 includes a liquid replenishment mechanism 2031 and a negative pressure mechanism 2032. The liquid replenishment mechanism 2031 is configured to perform liquid replenishment for the replacement component and at least part of the maintenance unit 201; the negative pressure mechanism 2032 is configured to provide a negative pressure environment for the replacement component and at least part of the maintenance unit 201. It can be understood that the liquid replenishment mechanism 2031 can communicate with at least part of the maintenance unit 201, so as to perform liquid replenishment for at least part of the maintenance unit 201. For example, the liquid replenishment mechanism 2031 can be connected to and communicate with at least one of the main maintenance pipeline 2011, the maintenance liquid distributor 2012, the first maintenance pipeline 2013, the second maintenance pipeline 2014, and a third maintenance pipeline according to actual needs. Exemplarily, the liquid replenishment mechanism 2031 can be connected to and communicate with the maintenance liquid distributor 2012.

Referring to Fig. 4, exemplarily, the liquid replenishment mechanism 2031 includes a liquid storage tank 20311 and a weighing scale 20312. The liquid storage tank 20311 is configured to store the liquid cooling medium, and the weighing scale 20312 is configured to monitor the weight change of the liquid storage tank 20311, so as to be configured to determine the amount of liquid replenishment. Exemplarily, the negative pressure mechanism 2032 includes a vacuum pump.

Referring to Fig. 4 and Fig. 6, in some implementations, the liquid replenishment mechanism 2031 and the second maintenance pipeline 2014 are disposed on one side of the maintenance liquid distributor 2012, and the first maintenance pipeline 2013, the main maintenance pipeline 2011, and at least part of the negative pressure mechanism 2032 are disposed on the other opposite side of the maintenance liquid distributor 2012, so as to fully utilize the space around the maintenance liquid distributor 2012, reasonably layout the maintenance device 200, make the structure of the maintenance device 200 more compact, and occupy small space.

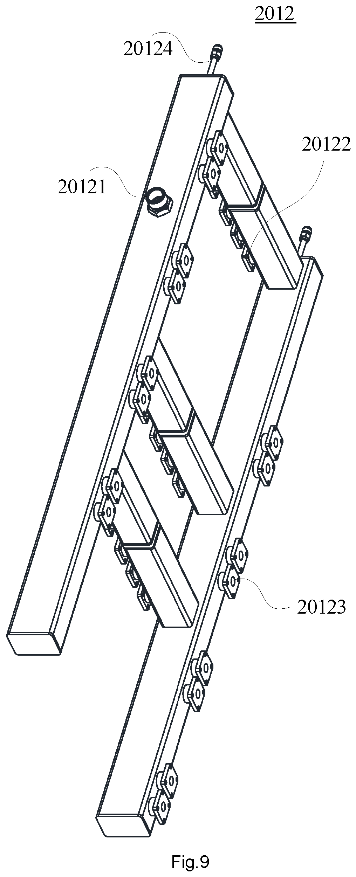

Referring to Fig. 9, in some embodiments, the maintenance liquid distributor 2012 includes a first connection interface 20121, a second connection interface 20122, a third connection interface 20123, and a fourth connection interface 20124. The first connection interface 20121 is configured to connect to the main maintenance pipeline 2011. The second connection interface 20122 is configured to connect to the first maintenance pipeline 2013 or a first pipeline of the liquid cooling system 100. The third connection interface 20123 is configured to connect to the second maintenance pipeline 2014 or the first pipeline of the liquid cooling system 100. The fourth connection interface 20124 is configured to connect to a pipeline of the pre-treatment unit 203. In other embodiments, one of the third connection interface 20123 and the fourth connection interface 20124 can also be omitted.

Referring to Fig. 3, in some embodiments, the maintenance device 200 further includes a control unit 204. The liquid replenishment mechanism 2031 and the negative pressure mechanism 2032 are signal-connected to the control unit 204, so that the control unit 204 can control the liquid replenishment mechanism 2031 to perform liquid replenishment and control the negative pressure mechanism 2032 to perform vacuum pumping. Exemplarily, the control unit 204 includes a circuit board or a control circuit, etc.

Referring to Fig. 4 and Fig. 3, in some embodiments, the maintenance device 200 further includes a recovery unit 205. The recovery unit 205 is configured to recover a liquid cooling medium of at least one of the components to be replaced and at least part of the maintenance unit 201. Exemplarily, the recovery unit 205 can recover the liquid cooling medium of components of the liquid cooling system 100, and can also recover the liquid cooling medium of at least part of the maintenance unit 201. For example, after the maintenance device 200 completes maintenance of the component to be replaced, the liquid cooling medium of any pipeline or component of the maintenance device 200 can be recovered through the recovery unit 205.

Referring to Fig. 3, in some implementations, a solenoid valve S1 of the negative pressure mechanism 2032, a solenoid valve S2 of the liquid replenishment mechanism 2031, and a solenoid valve S3 of the recovery unit 205 are respectively signal-connected to the control unit 204. In this way, at least one of the following operations can be controlled through the control unit 204: the negative pressure mechanism 2032 performing vacuum pumping, the liquid replenishment mechanism 2031 performing liquid replenishment, and the recovery unit 205 recovering the liquid cooling working medium, thereby improving the operational efficiency of the maintenance device 200. For example, the control unit 204 can control the solenoid valve S1 to open, and the solenoid valve S2 and the solenoid valve S3 to close. At this time, vacuum pumping can be performed on all pipelines of the maintenance device 200 through the maintenance liquid distributor 2012 and the negative pressure mechanism 2032. For another example, the control unit 204 can control the solenoid valve S2 to open, and the solenoid valve S1 and the solenoid valve S3 to close. At this time, liquid cooling medium can be filled into all pipelines of the maintenance device 200 through the liquid replenishment mechanism 2031. For yet another example, after online maintenance or replacement of the component to be replaced is completed, the control unit 204 can control the solenoid valve S3 to open, and the solenoid valve S1 and the solenoid valve S2 to close. At this time, the liquid cooling medium of all pipelines of the maintenance device 200 can be recovered through the recovery unit 205.

Referring to Fig. 4 and Fig. 6, exemplarily, the recovery unit 205 and the second maintenance pipeline 2014 are disposed on a same side of the maintenance liquid distributor 2012, so as to reasonably arrange the positions of the recovery unit 205 and the second maintenance pipeline 2014, reasonably utilize the space of the maintenance device 200, make the structure of the maintenance device 200 compact, and occupy small space.

Referring to Fig. 4, exemplarily, the recovery unit 205 includes a recovery tank 2051, configured to store the recovered liquid medium. Exemplarily, the recovery unit 205 further includes a recovery machine 2052. The recovery machine 2052 is signal-connected to the control unit 204. The control unit 204 can control the recovery machine 2052 to work, so that the liquid cooling medium of at least one of the component to be replaced and at least part of the maintenance unit 201 can be recovered to the recovery tank 2051.

Referring to Fig. 3, in some embodiments, the maintenance device 200 further includes a power supply unit 206. The power supply unit 206 is configured to supply power to electrical components of the maintenance device 200. Exemplarily, the electrical components include at least one of the following: the storage mechanism 2021, the weighing scale 20312, the solenoid valve, the negative pressure mechanism 2032, and the control unit 204.

In some embodiments, the maintenance unit 201 further includes a third maintenance pipeline (not labeled). The third maintenance pipeline is configured to maintain a first pipeline connected to the heat exchange component 20 in the liquid cooling pipeline assembly 30 of the liquid cooling system 100. Exemplarily, the first pipeline includes the first tertiary branch 33 or the second tertiary branch 36 of the liquid cooling system 100.

Referring to Fig. 4, in some embodiments, the maintenance device 200 further includes a frame 207. The maintenance liquid distributor 2012 is disposed on the frame 207. Exemplarily, the hose reel unit 202 is connected to the frame 207. Exemplarily, at least one of the liquid replenishment mechanism 2031, the negative pressure mechanism 2032, and the recovery unit 205 is disposed on the frame 207. Exemplarily, the third maintenance pipeline is detachably connected to the frame 207, or, the third maintenance pipeline is carried on the frame 207; so that when the first pipeline needs to be maintained, the third maintenance pipeline can be quickly removed from the frame 207; and after the maintenance of the first pipeline is completed, the third maintenance pipeline can be quickly placed on the frame 207.

Embodiments of the present disclosure further provide a liquid cooling system assembly, including the liquid cooling system 100 and the maintenance device 200 of any one of the above embodiments. The maintenance device 200 is configured to maintain the liquid cooling system 100 or the liquid cooling pipeline assembly 30 of the liquid cooling system 100.

Exemplarily, the liquid cooling system 100 includes the liquid cooling system 100 of any one of the above embodiments.

Embodiments of the present disclosure further provide a maintenance method for the liquid cooling system 100. The liquid cooling system 100 includes a liquid cooling source 10, a heat exchange component 20, and a liquid cooling pipeline assembly 30. The maintenance method includes the following operations.

A component to be replaced of the liquid cooling system 100 is replaced with a replacement component, and at least part of the maintenance device 200 is installed after one end of the component to be replaced is removed and before the replacement component is installed, so that a liquid cooling medium can circulate and flow between the liquid cooling source 10 and the heat exchange component 20, where the maintenance device 200 includes the maintenance device 200 of any one of the above embodiments.

The maintenance method of the above embodiment can reduce the liquid interruption time of the heat exchange component 20, reduce the risk of overheating of the component to be cooled, and achieve on-site maintenance or replacement of the component to be replaced without stopping the component to be cooled.

In some embodiments, the operation of replacing a component to be replaced of the liquid cooling system 100 with a replacement component, and installing at least part of the maintenance device 200 after one end of the component to be replaced is removed and before the replacement component is installed includes the following operations.

Pre-treatment is performed on the maintenance unit 201 and the replacement component.

The main maintenance pipeline 2011 of the maintenance unit 201 is connected to the main delivery pipeline 31 or the liquid cooling source 10 of the liquid cooling system 100.

The heat exchange component 20 or the first pipeline of the liquid cooling pipeline assembly 30 is detached from a pipeline to be removed, where the pipeline to be removed includes the component to be replaced of the liquid cooling pipeline assembly 30.

The maintenance liquid distributor 2012 or a maintenance pipeline of the maintenance device 200 is connected to the heat exchange component 20, or, the maintenance liquid distributor 2012 or the maintenance pipeline of the maintenance device 200 is connected to the first pipeline, where the maintenance pipeline includes the first maintenance pipeline 2013 or the second maintenance pipeline 2014 of the maintenance device.

Other components connected to the component to be replaced in the pipeline to be removed are detached from the component to be replaced.

The other components connected to the component to be replaced in the pipeline to be removed are connected to the replacement component.

The maintenance liquid distributor 2012 or the maintenance pipeline of the maintenance device 200 is detached from the heat exchange component 20, or, the maintenance liquid distributor 2012 or the maintenance pipeline of the maintenance device 200 is detached from the first pipeline.

The replacement component is connected to the heat exchange component 20 or the first pipeline.

The main maintenance pipeline 2011 is detached from the main delivery pipeline 31 or the liquid cooling source 10.

Exemplarily, the operation of replacing a component to be replaced of the liquid cooling system 100 with a replacement component, and installing at least part of the maintenance device 200 after one end of the component to be replaced is removed and before the replacement component is installed, includes: performing pre-treatment on the maintenance unit 201 and the replacement component; connecting the main maintenance pipeline 2011 of the maintenance unit 201 to the main delivery pipeline 31 or the liquid cooling source 10 of the liquid cooling system 100; detaching the heat exchange component 20 or the first pipeline of the liquid cooling pipeline assembly 30 from a pipeline to be removed, where the pipeline to be removed includes the component to be replaced of the liquid cooling pipeline assembly 30; connecting the maintenance liquid distributor 2012 or a maintenance pipeline of the maintenance device 200 to the heat exchange component 20; detaching other components connected to the component to be replaced in the pipeline to be removed from the component to be replaced; connecting the other components connected to the component to be replaced in the pipeline to be removed to the replacement component; detaching the maintenance liquid distributor 2012 or the maintenance pipeline of the maintenance device 200 from the heat exchange component 20; connecting the replacement component to the heat exchange component 20; detaching the main maintenance pipeline 2011 from the main delivery pipeline 31 or the liquid cooling source 10.

Exemplarily, the operation of replacing a component to be replaced of the liquid cooling system 100 with a replacement component, and installing at least part of the maintenance device 200 after one end of the component to be replaced is removed and before the replacement component is installed, includes: performing pre-treatment on the maintenance unit 201 and the replacement component; connecting the main maintenance pipeline 2011 of the maintenance unit 201 to a main pipeline or the liquid cooling source 10 of the liquid cooling system 100; detaching the heat exchange component 20 or the first pipeline of the liquid cooling pipeline assembly 30 from a pipeline to be removed, where the pipeline to be removed includes the component to be replaced of the liquid cooling pipeline assembly 30; connecting the maintenance liquid distributor 2012 or a maintenance pipeline of the maintenance device 200 to the first pipeline; detaching other components connected to the component to be replaced in the pipeline to be removed from the component to be replaced; connecting the other components connected to the component to be replaced in the pipeline to be removed to the replacement component; detaching the maintenance liquid distributor 2012 or the maintenance pipeline of the maintenance device 200 from the first pipeline; connecting the replacement component to the heat exchange component 20 or the first pipeline; detaching the main maintenance pipeline 2011 from the main pipeline or the liquid cooling source 10. In this way, the component to be replaced can be rapidly replaced, reducing the liquid interruption time of the corresponding heat exchange component 20 when replacing the component to be replaced.

Exemplarily, the component to be replaced includes a component that is one level higher than the first pipeline, for example, including the first liquid distributor 32 or the second liquid distributor 35, etc., and the first pipeline includes the first tertiary branch 33 or the second tertiary branch 36.

In some embodiments, the component to be replaced includes a component that is one level higher than the first pipeline. The operation of detaching the heat exchange component 20 from the pipeline to be removed, and connecting the maintenance liquid distributor 2012 or the maintenance pipeline of the maintenance device 200 to the heat exchange component 20 includes the following operations.

The liquid inlet pipeline group 301 is detached from the first heat exchange component 21, and a first maintenance liquid inlet pipeline of the first maintenance pipeline 2013 is connected to the first heat exchange component 21; the liquid outlet pipeline group 302 is detached from the first heat exchange component 21, and a first maintenance liquid outlet pipeline of the first maintenance pipeline 2013 is connected to the first heat exchange component 21.

Exemplarily, the component to be replaced includes the first liquid distributor 32 of the liquid inlet pipeline group 301 or the second liquid distributor 35, or, the component to be replaced includes the first liquid distributor 32 of the liquid outlet pipeline group 302 or the second liquid distributor 35. The maintenance method for the liquid cooling system 100 includes the following operations.
(a) Pre-treatment is performed on the maintenance unit 201 and the replacement component.
(b) The main maintenance liquid inlet pipeline of the main maintenance pipeline 2011 is connected to a connector socket reserved on a three-way pipeline of the main delivery pipeline 31 of the liquid inlet pipeline group 301, and the main maintenance liquid outlet pipeline of the main maintenance pipeline 2011 is connected to a connector socket reserved on a three-way pipeline of the main delivery pipeline 31 of the liquid outlet pipeline group 302.
(c) The first maintenance liquid inlet pipeline and the first maintenance liquid outlet pipeline of the first maintenance pipeline 2013 are pulled out from the storage mechanism by a preset distance for waiting for plugging and unplugging; the liquid inlet pipeline group 301 is detached from the first heat exchange component 21, and the first maintenance liquid inlet pipeline of the first maintenance pipeline 2013 is connected to the first heat exchange component 21; the liquid outlet pipeline group 302 is detached from the first heat exchange component 21, and the first maintenance liquid outlet pipeline of the first maintenance pipeline 2013 is connected to the first heat exchange component 21; the above process is repeated to complete online switching of the first heat exchange component 21 corresponding to other first maintenance pipelines 2013.
(d) Referring to step (c), the above process is repeated to sequentially complete online switching of the second heat exchange component 22 corresponding to each second maintenance pipeline 2014.
(e) A connection component connected to the first liquid distributor 32 is detached from the first liquid distributor 32; the connection component is connected to the replacement component (a new first liquid distributor 32).
(f) The pipeline switching and restoration work of the first heat exchange component 21 and the second heat exchange component is completed according to the reverse operation processes of (c) and (d).
(h) The main maintenance liquid inlet pipeline of the main maintenance pipeline 2011 is detached from the connector socket reserved on the three-way pipeline of the main delivery pipeline 31 of the liquid inlet pipeline group 301, and the main maintenance liquid outlet pipeline of the main maintenance pipeline 2011 is detached from the connector socket reserved on the three-way pipeline of the main delivery pipeline 31 of the liquid outlet pipeline group 302.
(i) The recovery unit 205 is connected to the fourth connection interface 20124 of the maintenance liquid distributor 2012, and all liquid cooling media is recovered to the liquid storage tank 20311.

It can be understood that after the maintenance of the first liquid distributor 32 is completed, at least one of the main maintenance pipeline 2011, the first maintenance pipeline 2013, and the second maintenance pipeline 2014 can be at least partially stored in the corresponding storage mechanism 2021.

In some embodiments, the component to be replaced includes a first pipeline connected to the heat exchange component 20; the operation of replacing a component to be replaced of the liquid cooling system 100 with a replacement component and installing at least part of the maintenance device 200 after one end of the component to be replaced is removed and before the replacement component is installed includes: performing pre-treatment on the replacement component and at least part of the maintenance unit 201; detaching a first end of the first pipeline from the heat exchange component 20; connecting a third maintenance pipeline of the maintenance unit 201 to the heat exchange component 20; detaching a second end of the first pipeline from remaining pipelines of the liquid cooling system 100; connecting one end of the replacement component to the remaining pipelines; detaching the third maintenance pipeline from the heat exchange component 20; connecting the other end of the replacement component to the heat exchange component 20. In this way, the first pipeline can be rapidly replaced, reducing the liquid interruption time of the corresponding heat exchange component 20 when replacing the first pipeline. Exemplarily, the first pipeline includes the first tertiary branch 33 or the second tertiary branch 36 of the liquid cooling system 100.

In the description of the present disclosure, it should be noted that unless otherwise explicitly specified and limited, the terms "install", "connected", "connection", "mechanical coupling", "coupling" should be understood in a broad sense, for example, it can be a fixed connection, a detachable connection, or an integrated connection. It can be a mechanical connection or an electrical connection. It can be directly connected or indirectly connected through an intermediate medium, and it can be internal communication between two elements or an interaction relationship between two elements. Mechanical coupling or coupling of two components includes direct coupling and indirect coupling, for example, direct fixed connection, connection through a transmission mechanism, etc. For those of ordinary skill in the art, the specific meanings of the above terms in the present disclosure can be understood according to specific circumstances.

In the present disclosure, unless otherwise explicitly specified and limited, a first feature being "on" or "below" a second feature may include direct contact between the first and second features, or may include that the first and second features are not in direct contact but are in contact through another feature between them. Moreover, a first feature being "above", "over", or "on top of" a second feature includes the first feature being directly above and diagonally above the second feature, or merely indicates that the horizontal height of the first feature is higher than that of the second feature. A first feature being "below", "under", or "beneath" a second feature includes the first feature being directly below and diagonally below the second feature, or merely indicates that the horizontal height of the first feature is less than that of the second feature.

The above disclosure provides many different implementations or examples for implementing different structures of the present disclosure. To simplify the disclosure of the present disclosure, components and settings of specific examples are described above. Of course, they are merely examples and are not intended to limit the present disclosure. In addition, the present disclosure may repeat reference numerals and/or reference letters in different examples. Such repetition is for the purpose of simplicity and clarity and does not per se indicate a relationship between the various implementations and/or settings discussed. Furthermore, the present disclosure provides examples of various specific processes and materials, but those of ordinary skill in the art may realize the application of other processes and/or the use of other materials.

In the description of this specification, descriptions referring to terms such as "one implementation", "some implementations", "schematic implementation", "example", "specific example", or "some examples" intend to mean that specific methods, steps, features, structures, materials, or characteristics described in conjunction with the implementation or example are included in at least one implementation or example of the present disclosure. In this specification, the schematic representation of the above terms does not necessarily refer to the same implementation or example. Moreover, the specific methods, steps, features, structures, materials, or characteristics described can be combined in any one or more implementations or examples in a suitable manner.

The above are only specific implementations of the present disclosure, but the protection scope of the present disclosure is not limited thereto. Any person skilled in the art can easily think of various equivalent modifications or replacements within the technical scope disclosed by the present disclosure, and these modifications or replacements should be covered within the protection scope of the present disclosure. Therefore, the protection scope of the present disclosure should be subject to the protection scope of the claims.

## Claims

1. A maintenance device for maintaining a liquid cooling system, wherein the maintenance device comprises:
a maintenance unit, configured to replace at least part of the liquid cooling system after one end of a component to be replaced of the liquid cooling system is removed and before a replacement component is installed, so that a liquid cooling medium can circulate and flow between a liquid cooling source and a heat exchange component of the liquid cooling system; and
a hose reel unit, wherein the maintenance unit is at least partially stored in the hose reel unit; in a case where the maintenance unit maintains the component to be replaced, at least part of the maintenance unit located at the hose reel unit can be released; and in a case where the replacement component is installed, at least part of the maintenance unit located outside the hose reel unit can be stored in the hose reel unit.

2. The maintenance device according to claim 1, wherein the hose reel unit comprises:
a storage mechanism, wherein the maintenance unit is at least partially stored in the storage mechanism; and
a retraction mechanism, connected to the storage mechanism; in a case where the maintenance unit maintains the component to be replaced, at least part of the maintenance unit located at the storage mechanism can be released; and in a case where the replacement component is installed, the maintenance unit located outside the storage mechanism can be stored in the storage mechanism under an action of the retraction mechanism.

3. The maintenance device according to claim 2, wherein in a case where the maintenance unit maintains the component to be replaced, the storage mechanism can move along a first movement direction to release at least part of the maintenance unit outwardly; and in a case where the replacement component is installed, the hose reel unit can move along a second movement direction under an action of the retraction mechanism to store at least part of the maintenance unit located outside the hose reel unit into the hose reel unit, wherein the first movement direction is different from the second movement direction.

4. The maintenance device according to any one of claims 1 to 3, wherein the maintenance unit comprises:
a main maintenance pipeline, configured to communicate with the liquid cooling source; and
a maintenance liquid distributor, capable of communicating with the main maintenance pipeline, wherein the main maintenance pipeline is correspondingly provided with the hose reel unit.

5. The maintenance device according to any one of claims 1 to 3, wherein the maintenance unit comprises:
a main maintenance pipeline, configured to communicate with the liquid cooling source;
a maintenance liquid distributor, capable of communicating with the main maintenance pipeline; and
a first maintenance pipeline, wherein the first maintenance pipeline and the main maintenance pipeline are respectively connected to the maintenance liquid distributor; and at least one of the first maintenance pipeline and the main maintenance pipeline is correspondingly provided with the hose reel unit.

6. The maintenance device according to claim 5, wherein the main maintenance pipeline and the first maintenance pipeline are disposed on a same side of the maintenance liquid distributor.

7. The maintenance device according to claim 5, wherein the maintenance unit further comprises:
a second maintenance pipeline, connected to the maintenance liquid distributor, wherein at least one of the first maintenance pipeline, the second maintenance pipeline, and the main maintenance pipeline is correspondingly provided with the hose reel unit.

8. The maintenance device according to claim 7, wherein the first maintenance pipeline and the second maintenance pipeline are respectively disposed on opposite sides of the maintenance liquid distributor.

9. The maintenance device according to claim 7, further comprising:
a pre-treatment unit, wherein the pre-treatment unit is configured to perform at least one of the following pre-treatment functions: providing a negative pressure environment for the maintenance unit and the replacement component; performing liquid replenishment for the maintenance unit and the replacement component; and at least part of the pre-treatment unit and the second maintenance pipeline are disposed on a same side of the maintenance liquid distributor, or, at least part of the pre-treatment unit and the main maintenance pipeline are disposed on a same side of the maintenance liquid distributor.

10. The maintenance device according to claim 7, further comprising:
a recovery unit, configured to recover a liquid cooling medium of at least one of the component to be replaced and at least part of the maintenance unit; and the recovery unit and the second maintenance pipeline are disposed on a same side of the maintenance liquid distributor.

11. A liquid cooling system assembly, comprising:
a liquid cooling system; and
the maintenance device according to any one of claims 1 to 10, configured to maintain the liquid cooling system or a liquid cooling pipeline assembly of the liquid cooling system.

12. A maintenance method for a liquid cooling system, wherein the liquid cooling system comprises a liquid cooling source, a heat exchange component, and a liquid cooling pipeline assembly, the maintenance method comprising:
replacing a component to be replaced of the liquid cooling system with a replacement component, and installing at least part of a maintenance device after one end of the component to be replaced is removed and before the replacement component is installed, so that a liquid cooling medium can circulate and flow between the liquid cooling source and the heat exchange component, wherein the maintenance device being the maintenance device as claimed in any one of claims 1 to 10.

13. The maintenance method according to claim 12, wherein the replacing a component to be replaced of the liquid cooling system with a replacement component, and installing at least part of a maintenance device after one end of the component to be replaced is removed and before the replacement component is installed comprises:
performing pre-treatment on the maintenance unit and the replacement component;
connecting a main maintenance pipeline of the maintenance unit to a main delivery pipeline or the liquid cooling source of the liquid cooling system;
detaching the heat exchange component or a first pipeline of the liquid cooling pipeline assembly from a pipeline to be removed, wherein the pipeline to be removed comprises the component to be replaced of the liquid cooling pipeline assembly;
connecting a maintenance liquid distributor or a maintenance pipeline of the maintenance device to the heat exchange component, or, connecting the maintenance liquid distributor or the maintenance pipeline of the maintenance device to the first pipeline, wherein the maintenance pipeline comprises a first maintenance pipeline or a second maintenance pipeline of the maintenance device;
detaching other components connected to the component to be replaced in the pipeline to be removed from the component to be replaced;
connecting the other components connected to the component to be replaced in the pipeline to be removed to the replacement component;
detaching the maintenance liquid distributor or the maintenance pipeline of the maintenance device from the heat exchange component, or, detaching the maintenance liquid distributor or the maintenance pipeline of the maintenance device from the first pipeline;
connecting the replacement component to the heat exchange component or the first pipeline; and
detaching the main maintenance pipeline from the main delivery pipeline or the liquid cooling source.
